Europäisches Patentamt

European Patent Office

Office européen des brevets

(11) Veröffentlichungsnummer: **0 175 045**
**B1**

(12) **EUROPÄISCHE PATENTSCHRIFT**

(45) Veröffentlichungstag der Patentschrift: **02.01.91**

(51) Int. Cl.⁵: **H 05 K 3/42,** H 05 K 3/00, H 05 K 3/28

(21) Anmeldenummer: **85101532.1**

(22) Anmeldetag: **13.02.85**

(54) **Verfahren zur Herstellung von durchkontaktierten flexiblen Leiterplatten für hohe Biegebeanspruchung.**

(30) Priorität: **21.09.84 DE 3434672**

(43) Veröffentlichungstag der Anmeldung:
**26.03.86 Patentblatt 86/13**

(45) Bekanntmachung des Hinweises auf die
Patenterteilung:
**02.01.91 Patentblatt 91/01**

(84) Benannte Vertragsstaaten:
**AT BE DE FR GB IT NL SE**

(56) Entgegenhaltungen:
**DE-B-2 657 212**
**GB-A-2 063 571**

**Feinwerktechnik und Messtechnik 86 (1978) 7,
Seiten 327-335**

(73) Patentinhaber: **Firma Carl Freudenberg
Höhnerweg 2-4
D-6940 Weinheim/Bergstrasse (DE)**

(72) Erfinder: **Trogisch, Günter
Am Grundweg 78
D-6104 Seeheim/Jugenheim 1 (DE)**
Erfinder: **Kober, Horst
Vogelsbergstrasse 43
D-3550 Marburg (DE)**

EP 0 175 045 B1

**Beschreibung**

Die Erfindung betrifft ein Verfahren zur Herstellung von durchkontaktierten flexiblen Leiterplatten, welche für hohe Biegebeanspruchungen geeignet sind.

In der Elektronik werden für hohe dynamische Biegebeanspruchungen, z.B. in Plattenspeichern und Druckern, flexible Schaltungen eingesetzt, die eine glatte, extrem saubere Oberfläche aufweisen müssen, um Störungen der elektromechanischen Funktionen durch aus der flexiblen Leiterplatte losgelöste Teilchen zu vermeiden.

Die Anmelderin fertigt und vertreibt an Hersteller von Plattenspeichern durchkontaktierte flexible Leiterplatten, welche außerhalb des Biegebereiches zwei Schaltungslagen mit Durchkontaktierungen aufweisen. Sie werden innerhalb des Biegebereiches einseitig ausgeführt und besitzen gleich dicke Träger- und Deckfolien. Als Basismaterial dient eine beidseitig kupferkashierte Trägerfolie, z.B. aus Polyimid. Die Kupferfolie ist dabei über eine Kleberschicht mit der Trägerfolie verbunden.

Die Ausbildung der Durchkontaktierung und der Leiterbilder wird in herkömmlicher Weise im Subtraktionsverfahren (Ätzen) vorgenommen; dabei werden im Biegebereich die Leiterbahnen nur auf einer Seite ausgebildet und die andere Seite vollständig abgeätzt. Die Leiter werden sodann mit einer Deckfolie versehen, welche die gleiche Dicke wie die Trägerfolie aufweist.

In der Zeitschrift "Feinwerktechnik und Messtechnik", Carl Hanser Verlag, München, *86*(1978) 7, Seite n327—335, wird auf Seite 334 diesbezüglich bereits die große Zahl zerstörungsfrei erreichbarer Biegezyklen erwähnt und rechnerisch belegt für den Fall, daß der Biegebereich der Leiterplatte nur einseitig mit Leiterbahnen bestückt ist. Der Grund hierfür ist, daß die neutrale Faser bei dieser Ausgestaltung etwas in Richtung der Kupferbelegung verschoben ist, wodurch deren Biegebeanspruchung geringer wird.

An gleicher Stelle wird erkannt, daß nur bei einseitiger Leiterbelegung und bei gleicher Dicke von Deck- und Trägerfolie die neutrale Faser genau durch die Mitte der Leiterbahnen verläuft ("ideale Bedingungen"). Es wird formelmäßig nachgewiesen, daß in diesem Idealfall ein Minimum an Biegebeanspruchung resultiert. Diese Ausführungen weisen deutlich auf die Wichtigkeit des symmetrischen Aufbaues flexibler Leiterplatten im Biegebereich hin.

Leiterplatten für hohe Biegebeanspruchungen, die außerhalb des Biegebereiches zwei Schaltungslagen mit Durchkontaktierungen aufweisen, werden daher meist einseitig flexibel ausgeführt und besitzen gleich dicke Träger- und Deckfolien (symmetrischer Lagenaufbau). Als Basismaterial dient eine beidseitig kupferkaschierte Trägerfolie, z.B. aus Polyimid.

Die Kupferfolie ist dabei über eine Kleberschicht mit der Trägerfolie verbunden. Die Ausbildung der Durchkontaktierung und der Leiterbilder wird in herkömmlicher Weise im Subtraktionsverfahren (Ätzen) vorgenommen; dabei werden im Biegebereich die Leiterbahnen nur auf einer Seite ausgebildet und die andere Seite vollständig abgeätzt. Die Leiter werden sodann mit einer Deckfolie versehen, welche die gleiche Dicke wie die Trägerfolie aufweist.

Trotz diese symmetrisch erscheinenden Aufbaues liegen die Leiterbahnen nicht in dem Querschnittsbereich des Laminats, der sich bei Biegebelastung neutral verhält, d.h. weder Zugnoch Druckspannungen ausgesetzt ist ("neutrale Faser"). Die Kleberschicht der abgeätzten Trägerfolie erzeugt nämlich dennoch eine Asymmetrie, welche die neutrale Faser in andere Querschnittszonen verlegt. Ferner ist die Leiterplatte infolge des freiliegenden Klebstoffes anfällig für Staubablagerungen und Abrieb.

Es wurde von der Anmelderin auch versucht, die Trägerfolie des Basismaterials nur halb so dick zu wählen wie die Deckfolie auf der Leiterseite.

Zusätzlich wurde auf der abgeätzten Seite der Trägerfolie eine Deckfolie mit gleicher Dicke wie der Trägerfolie aufgebracht.

Zwar gibt es bei diesem Aufbau keine freiliegende Kleberschicht, jedoch läßt sich auch hier eine Symmetrie im Biegebereich nicht erreichen, was auf die Existenz der beiden Kleberschichten auf der Trägerfolie zurückzuführen ist.

Ferner kann die gesamte Dicke des Aufbaues im Biegebereich nicht so dünn und damit so flexibel ausgelegt werden, wie dies bei einseitig belegten Leiterplatten möglich ist.

Die DE—B 26 57 212 beschreibt ein Verfahren zur Herstellung von starre und flexible Bereiche aufweisende Leiterplatten durch Verpressen von starren und flexiblen Einzellagen mit Hilfe von im flexible gewünschten Bereich ausgesparten Verbundfolien und Entfernen der starren Außenlagen in den flexibel gewünschten Bereichen.

Die GB—A—20 63 571 nimmt auf ein Verfahren Bezug, mmit dem zumindest eine Leiterbahnenebene aufweisende, starr-flexible Leiterplatten hergestellt werden, indem man feste und flexible Einzel-Substratlagen aufeinander laminiert, dabei in den flexibel auszugestaltenden Bereichen jedoch keine Laminierung vornimmt und anschließend die in diesen Bereichen liegenden Teile der starren Substratlagen entfernt.

Ausgehend von der erstgenannten Literaturstelle besteht die Aufgabe der vorliegenden Erfindung darin, ein Verfahren aufzuzeigen, mit dem außerhalb des Biegebereiches endseitig mit zwei Schaltungslagen und Durchkontaktierungen versehene, flexible Leiterplatten für hohe Biegebeanspruchungen hergestellt werden können, welche im Biegebereich einen bzgl. der einzigen Leiterbahnebene symmetrischen Schichtenaufbau besitzen. Die Leiterbahnen sollen sich im diesem Bereich in der erwähnten neutralen Faser befinden, und freiliegende Kleberschichten sollen vermieden werden.

Diese Aufgabe wird durch die im kennzeichnenden Teil des Patentspruchs angegebenen Verfahrensschritte gelöst.

Das erfindungsgemäße Verfahren zeigt dabei einen sehr kostengünstigen Herstellungsweg auf.

Damit ist der im Stand der Technik geforderte Idealfall erreicht, daß Deck- und Trägerfolie in diesem Bereich bei einseitiger Leiterbelegung gleiche Schichtdicken haben. Unter diesen Bedingungen verläuft die neutrale Faser des Biegebereiches genau durch die Mitte der Leiterbahnebene, woraus hier ein Minimum für die Biegebeanspruchung resultiert. Die Leiterplatte übersteht demzufolge eine Vielzahl an Biegezyklen schadlos. Ferner ermöglicht der einfache Lagenaufbau mit dünnsten Schicht eine hohe Flexibilität, was zusätzlich der Lebensdauer der Schaltung zugute kommt. Trotz dieser Beschränkung auf wenige Schichten sind keine freiliegenden Kleberschichten vorhanden; übermäßige Staubablagerungen und Abrieb werden somit vermieden.

Eine Vortrennung von Einzellen entlang der Trennungslinie vom Beigebereich zum Durchkontaktierungsbereich ist nicht erforderlich, da die Kupferfolie über der Aussparung der Kleberschicht gleichzeitig mit dem Ätzen des Leiterbildes entfernt wird.

Ein Ausführungsbeispiel der Erfindung ist in der Zeichnung dargestellt und wird im folgenden näher erläutert.

Es zeigen:

Figur 1 den Aufbau eines flexiblen Verbundes im Querschnitt vor der Ausbildung der Durchkontaktierung und der Leiterbahnen;

Figur 2 den Verbund gemäß Figur 1 in der Draufsicht;

Figur 3 den Querschnitt der fertiggestellten flexiblen Leiterplatte.

Ausgegangen wird von einem einseitig metallkaschierten, flexiblen Basismaterial 3, bestehend aus einer Metallfolie 7, vorzugsweise Kupfer, einer Kleberschicht 6 sowie einer Trägerfolie 5.

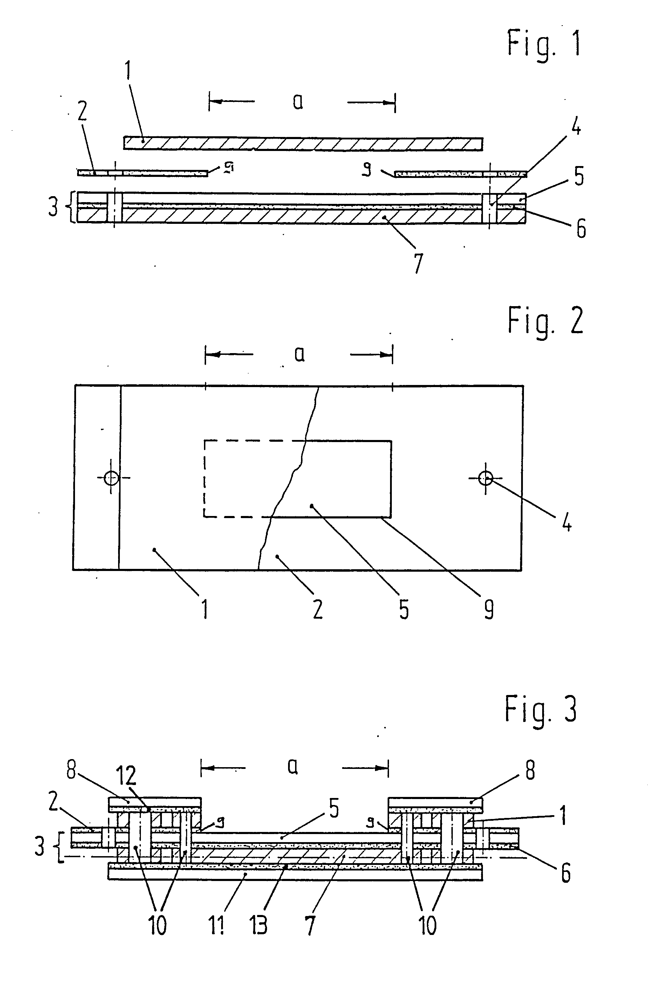

Der Trägerfolie 5 wird eine klebende Schicht 2, eine Klebefolie oder ein nicht fließendes Prepreg mit Hilfe von Registrierbohrungen 4 zugeordnet, wobei der Biegebereich a ausgespart bleibt. Danach wird auf die obere Kleberschicht 2 eine obere Kupferfolie 1 gelegt. Dieser Aufbau, wie er in Figur 1 gezeigt ist, wird nun zu einem flexiblen Verbund laminiert.

Die Weiterverarbeitung dieses Verbundes erfolgt folgendermaßen:

Die Lage der Durchkontaktierungen 10 und der für die Strukturierung der Leiterbahnen in der Leiterplattentechik stets erforderlichen Leiterbahnmasken wird mit Hilfe der Registrierbohrungen 4 festgelegt, wobei sich die Durchkontaktierungen 10 und die künftigen, auf der Seite der oberen Kupferfolie 1 befindlichen Leiterbahnen nur außerhalb der Aussparungen 9 befinden und die Leiterbahnen auf der Seite der unteren Kupferfolie 7, am flexiblen Basismaterial 3, innerhalb des Biegebereichs a exakt über der Aussparung 9 liegend vorgesehen werden.

Sodann werden die Leiterbahnbildet geätzt, wobei die Kupferfolie 1 gleichzeitig vollständig über der Aussparung 9 entfernt wird, so daß innerhalb der Biegebereichs a eine Schaltungslage und außerhalb des Bereichs a zwei Schaltungslagen entstehen. Die Trägerfolie 5 des Basismaterials 3 liegt dann frei.

Zuletzt wird auf die Leiterbahnbereiche 1 und 7 eine obere Deckfolie 8 bzw. untere Deckfolie 11 mit den zugehörigen Kleberschichten 12 bzw. 13 aufgebracht. Die obere Deckfolie 8 wird dabei im Biegebereich a vollständig ausgespart. Die untere Deckfolie 11 mit Kleberschicht 13 weist dieselbe Dick auf wie die Trägerfolie 5 mit der Kleberschicht 6.

Wie Figur 3 deutlich zeigt, liegt nach diesem einfachen, kostengünstigen Verfahren die einzige Leiterbahnebene des dynamisch beanspruchten Biegebereiches a genau in der neutralen Faser, d.h. in der bezüglich der beim Biegen auftretenden Kräfte neutralen Zone. Die Leiterplatte übersteht eine Vielzahl von Biegezyklen ohne Schaden. Sie weist keine freiliegenden Kleberschichten auf, obwohl Anzahl und Dicke der Schichten so gering wie möglich gehalten wurden.

Bezugzeichenliste
a dynamisch beanspruchter Biegebereich
1 Kupferfolie oben
2 Kleberschicht, -folie oben
3 einseitig kupferkaschiertes, flexibles Basismaterial
4 Registrierbohrungen
5 Trägerfolie
6 Kleberschicht unten
7 Kupferfolie unten
8 obere Deckfolie
9 Aussparung der Kleberschicht 2
10 Durchkontaktierungen
11 untere Deckfolie
12 Kleberschicht der Deckfolie 8
13 Kleberschicht der Deckfolie 11

**Patentanspruch**

Verfahren zur Herstellung von flexiblen Leiterplatten für hohe Biegebeanspruchungen, die außerhalb des Biegebereiches (a) endseitig zwei Schaltungslagen (1, 7) mit Durchkontaktierungen (10) aufweisen und deren Schichtenaufbau im Biegebereich (a) zur einzigen Leiterbahnebene symmetrisch ist, mit den Verfahrensschritten.

Anbringen von Registrierbohrungen (4) auf einem einseitig kupferkaschierten, flexiblen Basismaterial (3), bestehend aus einer Trägerfolie (5), einer unteren Kuberschicht (6) und einer unteren Kupferfolie (7);

Zuordnen einer oberen Kleberschicht (2) mit Hilfe der Registrierbohrungen (4) auf die Trägerfolie (5) des Basismaterials (3) unter Aussparen des Biegebereichs (a);

Auflegen einer oberen Kupferfolie (1) auf die obere Kleberschicht (2);

Laminieren der Schichten;

Positionieren der Durchkontaktierungen (10) und von Leiterbahnmasken mit Hilfe der Registrierbohrungen (4), wobei die Durchkontaktierungen (10) und die Leiterbahnen auf der oberen Kupferfolie (1) nur außerhalb der Aussparung (9) der oberen Kleberschicht (2), die Leiterbahnen der unteren Kupferfolie (7) des flexiblen Basismaterials (3) hingegen innerhalb des Biegebereichs (a), exaktunter der Aussparung (9) der oberen Kleberschicht (2) liegend, vorgesehen werden;

Ätzen der so positionierten Leiterbahnbilder und gleichzeitig vollständiges Entfernen der oberen Kupferfolie (1) mittels Ätzen über der Aussparung (9);

Abdecken der Leiterbahnbereiche (1) und (7) mit einer unteren (11) und oberen (8) Deckfolie mit zugehörigen Kleberschichten (13) bzw. (12), wobei die obere Deckfolie (8) den Biegebereich (a) vollständig ausspart und die untere Deckfolie (11) — einschließlich deren Kleberschicht (13) — die gleiche Dicke besitzt wie die Trägerfolie (5) mit unteren Kleberschicht (6).

## Revendication

Procédé pour la fabrication de cartes flexibles à circuits imprimés destinées à des sollicitations importantes de flexion, qui présentent, en dehors de la zone de flexion (a), sur la face terminale, deux couches de circuits (1, 7) munies de trous de métallisation (10), et dont le stratifié, dans la zone de flexion (a), est symétrique par rapport à l'unique plan de pistes conductives, ce procédé comprenant les étapes opératoires consistant à:

pratiquer des alésages de correspondance (4) sur une matière de base (3) flexible, recouverte d'un côté par une feuille mince de cuivre, cette matière étant constituée par une feuille mince de support (5), une couche adhésive inférieure (6) et une feuille mince inférieure de cuivre (7);

adjoindre à la feuille mince de support (5) de la matière de base (3) une couche adhésive supérieure (2) à l'aide des alésages de correspondence (5), tout en évidant la zone de flexion (a);

déposer une feuille mince supérieure de cuivre (1) sur la couche adhésive supérieure (2);

lamifier les couches;

positionner les trous métallisés (10) et les masques de pistes conductives à l'aide des alésages de correspondance (4), les trous métallisés (10) et les pistes conductives situées sur la feuille mince supérieure de cuivre (1) n'étant prévus qu'en dehors de l'évidement (9) de la couche adhésive supérieure (2), les pistes conductives de la feuille mince supérieure de cuivre (7) de la matière flexible de base (3) étant au contraire prévues au sein de la zone de flexion (a), exactement en dessous de l'évidement (9) de la couche adhésive supérieure (2);

graver les placages métalliques sélectifs ainsi positionnés et, en même temps, éliminer complètement la feuille mince supérieure de cuivre (1) en procédant à un gravage par-dessus l'évidement (9);

recouvrir les zones (1 et 7) des pistes conductives par une feuille mince inférieure (11) et supérieure (8) de recouvrement munies de leurs couches adhésives correspondantes (13 ou 12), la feuille mince supérieure de recouvrement (8) laissant complètement libre la zone de flexion (a) et la feuille mince inférieure de recouvrement (11) — y compris sa couche adhésive (13) — ayant la même épaisseur que celle de la feuille mince de support (5) avec la couche adhésive inférieure (6).

## Claim

A method for manufacturing flexible printed circuit boards for high bending stresses, which boards have, at the ends outside the bending region (a), two circuit layers (1, 7) with plated through-connections (10), and the layer structure of which is symmetrical in the bending region (a) to the individual conductor track level, having the method steps:

alignment bores (4) are put in a flexible base material (3) copper-coated on one side and composed of a carrier film (5), a lower adhesive layer (6) and a lower copper foil (7);

an upper adhesive layer (2) is arranged with the aid of the alignment bores (4) on the carrier film (5) of the base material (3) accompanied by cutting out of the bending region (a);

an upper copper foil (1) is applied to the upper adhesive layer (2);

the layers are laminated;

the plated through-connections (10) and conductor track masks are positioned with the aid of the alignment bores (4), the plated through-connections (10) and the conductor tracks on the upper copper foil (1) being provided only outside the cut-out (9) of the upper adhesive layer (2), the conductor tracks of the lower copper foil (7) of the flexible base material (3) lying, in contrast, within the bending region (a), exactly below the cut-out (9) of the upper adhesive layer (2);

the conductor track patterns positioned in this way are etched and at the same time the upper copper film (1) is completely removed by etching above the cut-out (9);

the conductor track regions (1) and (7) are covered with associated adhesive layers (13) and (12) respectively, the upper covering film (8) leaving the bending region (a) completely open and the lower covering film (11) — including its adhesive layer (13) — having the same thickness as the carrier film (5) with the lower adhesive layer (6).

# Fig. 1

# Fig. 2

# Fig. 3